Europäisches Patentamt

European Patent Office

Office européen des brevets

(11) Veröffentlichungsnummer: **0 031 138 B1**

# EUROPÄISCHE PATENTSCHRIFT

(45) Veröffentlichungstag der Patentschrift:
27.07.83

(51) Int. Cl.³: **H 03 F 3/30, H 03 F 1/52**

(21) Anmeldenummer: **80107991.4**

(22) Anmeldetag: **17.12.80**

(54) Transistorgegentaktendstufe.

(30) Priorität: **21.12.79 DE 2951928**

(43) Veröffentlichungstag der Anmeldung:
**01.07.81 Patentblatt 81/26**

(45) Bekanntmachung des Hinweises auf die Patenterteilung:
**27.07.83 Patentblatt 83/30**

(84) Benannte Vertragsstaaten:
**FR GB NL**

(56) Entgegenhaltungen:
**FR-A-2 247 012**
**FR-A-2 291 641**
**US-A-3 484 708**
**US-A-3 727 148**
**US-A-3 992 678**

(73) Patentinhaber: **SIEMENS AKTIENGESELLSCHAFT, Berlin und München Wittelsbacherplatz 2, D-8000 München 2 (DE)**

(72) Erfinder: **Welzhofer, Klaus, Ruffini-Allee 30, D-8032 Gräfelfing (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

## Transistorgegentaktendstufe

Die Erfindung bezieht sich auf eine Transistorgegentaktendstufe mit Gegenkopplung vom Ausgang auf den Eingang sowie hochohmigem Eingang und niederohmigem Ausgang, bei der eine Ausgangsstufe vorgesehen ist, die pro Gegentaktstufe eine Parallelschaltung aus mehreren Ausgangstransistoren aufweist, wobei die Ausgangstransistoren der einen Gegentaktstufe komplementär zu den Ausgangstransistoren der anderen Gegentaktstufe ausgeführt sind, insbesondere für Impulsformer, wobei in jeder Gegentaktstufe als Eingangstransistor ein Feldeffekttransistor verwendet ist.

Aus der FR-A1-2 247 012 ist ein Leistungsverstärker bekannt, der eine Ausgangsstufe aus zwei Gegentaktstufen aufweist. Jede Gegentaktstufe besteht aus parallel angeordneten Ausgangstransistoren, wobei die Ausgangstransistoren der einen Gegentaktstufe komplementär zu den Ausgangstransistoren der anderen Gegentaktstufe sind. Der Aufbau der Ausgangsstufe ist derart, daß die als Ausgangstransistoren verwendeten Feldeffekttransistoren Triodenverhalten haben. Dazu ist es erforderlich, daß die Versorgungsspannung für die Ausgangsstufe konstant ist. Um mögliche Schwankungen der Versorgungsspannung zu kompensieren, wird der Ausgangsstufe eine Stufe vorgeschaltet, mit deren Hilfe die Gittervorspannung für die Feldeffekttransistoren gewonnen wird. Bei Änderungen der Versorgungsspannung werden die Gittervorspannungen so geändert, daß der Einfluß der Versorgungsspannungsänderungen kompensiert wird. Die bekannte Schaltung gibt jedoch keine Mittel an, durch die bei Auftreten eines Kurzschlusses am Ausgang die Zerstörung der Endstufe verhindert werden könnte.

Aus der US-A-3 484 708 ist ein Stromverstärker bekannt, der eine Endstufe aus parallel angeordneten Transistoren aufweist. Der Stromverstärker gibt einen Strom ab, der sich aus einem Konstantstrom und einem veränderbaren Strom besteht. Wenn Überlast auftritt, wird der veränderbare Strom, der von einem Kondensator geliefert wird, verkleinert. Dieser Stromverstärker ist nicht für Gegentaktbetrieb geeignet.

Die der Erfindung zugrundeliegende Aufgabe besteht darin, eine Transistorgegentaktendstufe derart aufzubauen, daß bei Kurzschluß am Ausgang die Endstufe nicht zerstört wird. Diese Aufgabe wird bei einer Transistorgegentaktendstufe der eingangs angegebenen Art dadurch gelöst, daß der Feldeffekttransistor jeweils über eine Emitterfolgerstufe die Basen der Ausgangstransistoren der zugeordneten Parallelschaltung ansteuert, daß die Basen der Ausgangstransistoren außerdem an eine Konstantstromquelle angeschlossen sind, die bei Überspannung am Ausgang abgeschaltet wird, und daß Mittel zur Stromversorgung vorgesehen sind, die abhängig vom Spannungshub und der Impulsgrundspannung eines Signales gesteuert sind.

Durch diese Maßnahmen erhält man eine Endstufe, die insbesondere zum Einsatz bei Impulsformern, die in Prüfsystemen verwendet werden, geeignet ist, da diese Endstufe den Fehlermöglichkeiten der Prüflinge angepaßt ist, d. h. Kurzschlüsse bzw. Rückspeisung gegen oder von den in einem Prüfsystem vorkommenden Versorgungsspannungen können die Endstufe nicht zerstören. Sie kann sowohl Leistung aufnehmen als auch Leistung abgeben, wobei die Ausgänge bei Überspannung abschaltbar sind.

Die Überspannungseinrichtung läßt sich dabei vorteilhafterweise derart ausbilden, daß in Reihe zur Konstantstromquelle jeder Gegentaktstufe ein gesteuerter Schalter vorzugsweise ein Transistor liegt, der bei unzulässigen Überspannungen am Ausgang durch eine Überspannungsschaltung wie zum Beispiel eine bistabile Kippstufe, betätigt wird.

Die schwimmende Stromversorgung kann dabei in geeigneter Weise so ausgebildet werden, daß sie je Gegentaktstufe aus einem Operationsverstärker mit nachgeschalteten Leistungstransistoren besteht, in deren Emitterkreis Widerstände eingeschaltet sind, durch die zugleich der Ausgangsstrom der jeweiligen Gegentaktstufe fließt und daß im Basis-Emitter-Kreis dieser Leistungstransistoren jeweils die Kollektorstrecke eines weiteren Transistors liegt, dessen Basis jeweils am Verbindungspunkt vom Emitter der Leistungstransistoren und der Meßwiderstände liegt.

Eine besonders günstige Ausführungsform für die schwimmende Stromversorgung besteht dabei darin, daß die Steuereingänge der Operationsverstärker in der Brückendiagonale einer Wheatston'schen Brücke liegen, an die auch als Steuergrößen die Hubspannung und die Impuls-Grundspannung des Signals geführt sind.

Zur Erhöhung der Kurzschlußfestigkeit ist es vorteilhaft, daß zwischen den Operationsverstärkern und den Leistungstransistoren Dioden eingeschaltet sind.

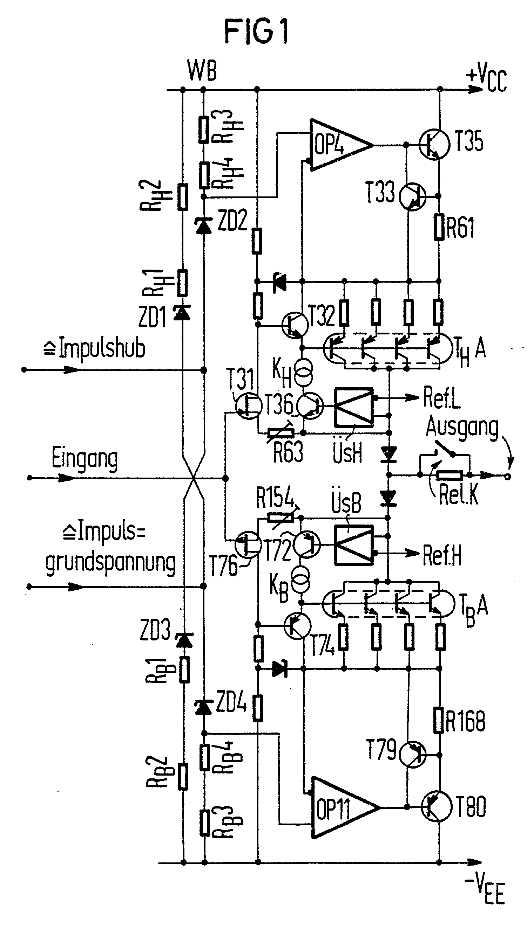

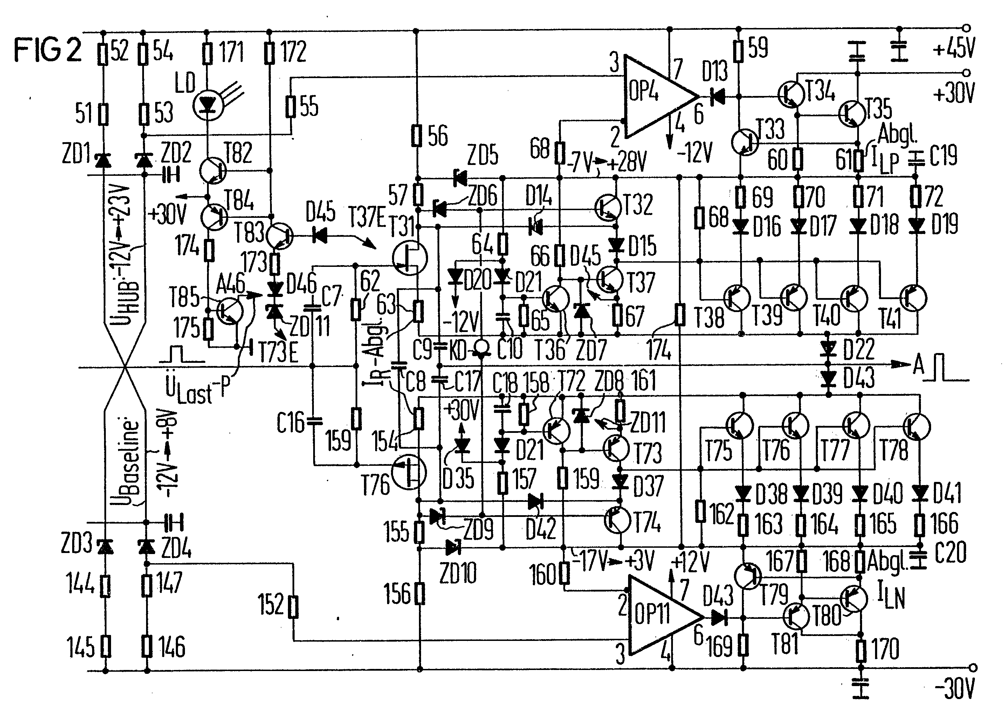

Anhand der Ausführungsbeispiele nach den Fig. 1 und 2 wird die Erfindung näher erläutert. Es zeigt dabei

Fig. 1 ein vereinfachtes Schaltbild der Gegentaktendstufe,

Fig. 2 ein ausführliches Schaltbild der gleichen Gegentaktendstufe.

Die Endstufe ist aus zwei Hälften spiegelbildlich aufgebaut, wobei jede Hälfte durch ihre eigene Leistungskonstantspannungsquelle (OP11/T80 und OP4/T35) mit Strom versorgt wird. Die Führungsspannungen für die jeweilige Spannungsquelle werden über die Zenerdioden ZD2 und ZD4 aufgesetzt auf die programmierbare Spannung $U_{HUB}$ bzw. $U_{BASIS}$ gewonnen. Damit ergibt sich eine schwimmende Stromversorgung für die Endstufenhalbleiter $T_HA$ bzw. $T_BA$, was den Vorteil hat, daß die Endstufentransistoren im Normalbetrieb mit konstanter und niedriger Verlustleistung arbeiten, wogegen die größere Verlustleistung in den Stromversorgungstransistoren T80 und T35 anfällt.

Die Leistungshalbleiter T80 und T35 sind bis zum Ansprechen des Überspannungsschutzes (ÜsB bzw. ÜsH) durch die Transistoren T33 und T79 vor Überlastung geschützt. Hierbei messen die Transistoren T33 oder T79 den ausgangsstromabhängigen Spannungsabfall an den Widerständen R61 bzw. R168 und begrenzen dadurch den Ausgangsstrom auf den zulässigen Wert. Der Ausgang wirkt in diesem Fall als Konstantstromquelle. Wird am Ausgang im Kurzschlußfall eine Spannung negativer als die interne Referenzspannung Ref L, oder eine Kurzschlußspannung positiver als die Referenzspannung Ref H niederohmig angelegt, so sprechen die Überwachungsschutzschaltungen ÜsB bzw. ÜsH an, die dann jeweils die Transistoren T72 bzw. T36 sperren, wodurch die Endstufentransistoren $T_BA$ oder $T_HA$ von den Konstantstromquellen $K_B$ oder $K_H$ keinen Basisstrom mehr erhalten, was dann zu deren Abschaltung führt.

In diesem Fall muß der Überspannungskurzschluß am Ausgang beseitigt werden, da sonst die Endstufe selbsttätig nicht mehr in den aktiven Betrieb zurückkehrt. Mit den Widerständen R63 und R154 wird der Ruhe-Querstrom der Endstufe eingestellt. Relaiskontakt $Rel_K$ schaltet den Ausgangswiderstand um.

Hinter den Zenerdioden ZD2 und ZD4 werden über die Widerstände $R_{55}$ und $R_{152}$ die Führungsspannungen für die Stromversorgung der Endstufe abgegriffen.

Die Stromversorgung für die positive Hälfte der Endstufe ist aus den Bauteilen $OP4/D_{13}/T_{33}/T_{34}$ und $T_{35}$ aufgebaut und wird von der Hubspannung geregelt.

Die Stromversorgung für die negative Hälfte der Endstufe ist aus den Bauteilen $OP11/D_{43}/T_{79}/T_{80}$ und $T_{81}$ aufgebaut und wird von der Impuls-Grundspannung geregelt. Jede der beiden Stromversorgungen stellt im Prinzip einen Spannungsfolger dar, dessen Ausgangsspannung durch die Gegenkopplung über die Widerstände $R_{68}$ bzw. $R_{160}$ der Führungsspannung nachgezogen wird:

$$U_{OP4}6 = U_{OP4}3 + J_{10} \cdot R_{61} + U_{BE}T_{35} + U_{BE}T_{24} - U_D13$$
$$U_{OP11}6 = U_{OP11}3 + J_{LS} \cdot R_{168} - U_{BE}T_{80} - U_{BE}T_{81} + U_D43$$

$J_{LQ}$ = Quellenstrom des Ausgangs A
$J_{LS}$ = Senkenstrom des Ausgangs A

Die Führungsspannungen sind durch die Zenerdioden ZD2 bzw. ZD4 so ausgelegt, daß sich die Stromversorgung für jede Hälfte der Endstufe auf z. B. 5 Volt Überspannung gegenüber der programmierten Grundspannung bzw. Hubspannung einstellt.

Die Transistoren $T_{33}$ und $T_{79}$ messen jeweils den belastungsabhängigen Spannungsabfall an den Widerständen $R_{61}$ und $R_{168}$. Erreicht dieser Spannungsabfall einen Wert, bei dem bei den Transistoren $T_{33}$ und $T_{79}$ ein Basisstrom zu fließen beginnt, so werden diese Transistoren leitend und übernehmen dadurch die Basisströme der Transistoren $T_{34}$ und $T_{81}$. Diese Halbleiter sind somit gesperrt. Sind $T_{35}$ oder $T_{80}$ gesperrt, dann ist auch der Strom durch $R_{61}$ oder $R_{168}$ abgeschaltet, der Überstromfall also wieder aufgehoben, was zu einem erneuten Einschalten der Halbleiter $T_{35}$ bzw. $T_{80}$ führt; es entsteht somit eine lastabhängige Kippschwingung, deren Amplitude durch die Kapazitäten $C_{19}$ und $C_{20}$ geglättet wird. Die Dioden $D_{13}$ und $D_{43}$ trennen beim Einschalten der Überstromtransistoren $T_{33}$ und $T_{79}$ die Ausgänge der Operationsverstärker OP4 und OP11 von der Last ab und verhindern dadurch im Kurzschlußfall deren Zerstörung.

Die Endstufe ist komplementär aufgebaut, wobei jede Hälfte eine im Prinzip über die Widerstände $R_{63}$ und $R_{154}$ gegengekoppelte Spannungsfolger-Impedanzkonverter-Stufe darstellt. Der Eingangsimpuls gelangt über die Bauteile $C_7/R_{62}$ und $C_{16}/R_{159}$ an die »Gates« der Feldeffekt-Transistoren $T_{31}$ und $T_{76}$. $T_{31}$ und $T_{76}$ sind selbstleitende Sperrschicht-FET's, die in Source-Schaltung betrieben werden, mit der Spannungsverstärkung:

$$V_T31 \approx S \cdot R_{57}$$

$$V_T76 \approx S \cdot R_{155}$$

$$S = \frac{2 J_{DS}}{U_P2} (U_{GS} - U_P)$$

$$S = \text{Steilheit des FET} \quad \frac{mA}{V}$$

$$J_{DS} = \text{Drainstrom bei } U_{GS} = 0$$

$$U_P = \text{Abschnürspannung für } J_D = 0$$

$U_{GS}$ = Gate-Source-Spannung

Der nun an den »Drains« der Feldeffekt-Transistoren $T_{31}$ und $T_{76}$ jeweils anstehende phasengedrehte Impuls wird nun über Zenerdioden ZD6 bzw. ZD9 gleichspannungsverschoben an die Basen der Halbleiter $T_{32}$ bzw. $T_{74}$ angelegt. Der Konstantstromgenerator KD sorgt dafür, daß obige Zenerdioden ständig leitend sind. Diese Maßnahmen bewirken, daß die beiden Feldeffekt-Transistoren mit größerer $U_{DS}$ arbeiten, wodurch eine lineare Verstärkung über den gesamten Ansteuerbereich erreicht wird. Die beiden Zenerdioden ZD5 und ZD10 vergrößern für diesen Zweck die Versorgungsspannungen an den Drain-Widerständen $R_{57}$ und $R_{155}$; diese Spannungen schwimmen ebenfalls DC-versetzt relativ zu den programmierungsabhängigen Endstufen-Versorgungsspannungen mit.

Die Transistoren $T_{32}$ und $T_{74}$ arbeiten in Kollektorschaltung (Emitterfolger), wobei deren Basis-Emitter-Strecke, durch die Dioden $D_{14}$ bzw. $D_{42}$ im Überspannungs-Kurzschlußfall gegen einen zerstörenden Durchbruch geschützt werden.

Die Bauteile $T_{37}$/ZD7/$R_{67}$ und $T_{73}$/ZD8/$R_{161}$ bilden über die Dioden $D_{15}$ und $D_{37}$ für die Emitterfolger $T_{32}$ und $T_{74}$ eine Konstantstromlast mit:

$$J_C T_{37} = \frac{/U_{ZD}7/ - /U_{BE}T_{37}/}{R_{67}} \cdot \left(1 - \frac{1}{B_{T_{37}}}\right)$$

$B_{T_{37}}$ = Stromverstärkung von $T_{37}$

$$J_C T_{73} = \frac{/U_{ZD}9/ - /U_{BE}T_{73}/}{R_{161}} \cdot \left(1 - \frac{1}{B_{T_{73}}}\right)$$

$B_{T_{73}}$ = Stromverstärkung von $T_{73}$

Die Halbleiter $T_{36}$ und $T_{72}$ schalten im Überspannungs-Kurzschlußfall obige Stromquellen aus, wodurch dann auch die Endstufentransistoren $T_{38}$, $T_{39}$, $T_{40}$, $T_{41}$ bzw. $T_{75}$, $T_{76}$, $T_{77}$, $T_{78}$ keinen Basisstrom mehr erhalten und über die Widerstände $R_{68}$ und $R_{162}$ gesperrt werden.

Wird z. B. die Kurzschluß-Überspannung am Ausgang

$-12\,V - /U_{BE}T_{36}/$ oder
$+30\,V + /U_{BE}T_{72}/$

so wird $T_{36}$ oder $T_{72}$ leitend und somit die Abschaltroutine aktiviert.

Die Bauteile $C_{10}$/$R_{64}$ bzw. $C_{18}$/$R_{157}$ bilden je ein Integrierglied, wodurch obige Abschaltroutine gemäß

$$U_{BT}37 = \frac{1}{R64 \cdot C10} \int U_{Üsp} \cdot dt$$

$U_{BT}37$ = Spannung an der Basis von $T_{37}$

$U_{Üsp}$ = Differenzspannung $-12\,V$ zur einspeisenden Überspannung

$$U_{BT}72 = \frac{1}{R157 \cdot C18} \int U_{Üsp} \cdot dt$$

$U_{BT}72$ = Spannung an der Basis von $T_{72}$

$U_{Üsp}$ = Differenzspannung $+30\,V$ zur einspeisenden Überspannung

etwas verzögert anspricht. Dadurch wird erreicht, daß kurze Überspannungs-Nadelimpulse (z. B. Reflexionen an fehlabgeschlossenen Ausgangsleitungen etc.) die Endstufe noch nicht abschalten.

Die Endstufe selbst wird aus jeweils vier parallel geschalteten Transistoren $T_{38}$ bis $T_{41}$ und $T_{75}$ bis $T_{78}$ gebildet, wobei die Dioden $D_{16}$ bis $D_{19}$ und $D_{38}$ bis $D_{41}$ jeweils temperaturkompensierend zur Diode $D_{15}$ bzw. $D_{37}$ wirken, die Widerstände $R_{69}$ bis $R_{72}$ bzw. $R_{163}$ bis $R_{166}$ dagegen die exemplarabhängigen Parameterstreuungen der Endstufentransistoren durch Stromgegenkopplung ausgleichen. Für die Spannungsverstärkung jeder Endstufenhälfte gilt näherungsweise:

$$V = \frac{\Delta U_A}{\Delta U_E} = \frac{R_c}{R_{69}/R_{70}//R_{71}//R_{72}}$$

$$V = \frac{\Delta U_A}{\Delta U_E} = \frac{R_c}{R_{163}/R_{164}//R_{165}//R_{166}}$$

$R_c$ = Ohmscher Abschlußwiderstand am Ausgang

Für die Gesamtspannungsverstärkung jeder Endstufenhälfte multipliziert sich also die Spannungsverstärkung der jeweiligen FET-Eingangsstufe mit der Spannungsverstärkung der Ausgangsstufe. Durch die Rückkopplung über die Widerstände $R_{63}$ bzw. $R_{154}$ ergibt sich aber eine Gesamtspannungsverstärkung von 1; der Ausgangswiderstand wird jedoch um den Faktor der Gesamtspannungsverstärkung reduziert.

Die Leistungsdioden $D_{22}$ und $D_{43}$ dienen ebenfalls als Überspannungsschutz, indem sie ein zerstörendes Umpolen der Basis-Kollektor- bzw. Kollektor-Emitter-Strecken der Endstufenhalbleiter verhindern. Dies würde dann geschehen, wenn z. B.

$U_{sp}A \leqq U_B T_{75}/T_{76}/T_{77}/T_{78}$ oder
$\ddot{U}_{sp}A \geqq U_B T_{38}/T_{39}/T_{40}/T_{41}$

$U_B$ = Basisspannung am T ...

wird.

Die Halbleiter $T_{82}$, $T_{83}$, $T_{84}$, $T_{85}$ bilden den Überspannungs-Kurzschlußindikator. Transistor $T_{83}$ wird im Normalbetrieb über die Bauteile $D_{45}$, $R_{173}$, $D_{46}$ und $ZD_{11}$ stromführend gehalten:

$$J_c T_{83} = \frac{U_E T_{37} + U_E T_{73} - (U_D 45 + U_{BE} T_{83} + U_D 46 + U_{ZD} 11)}{R_{173}} \left(1 - \frac{1}{B_T 83}\right)$$

$B_T 83$ = Stromverstärkung v. $T_{83}$

Dieser Kollektorstrom fließt durch die Basis von Transistor $T_{84}$, der dadurch gesättigt leitend gesteuert wird. Transistor $T_{82}$ dagegen ist gesperrt, so daß die Leuchtdiode LD nicht anspricht. Wegen des leitenden Transistors $T_{84}$ ist (über Widerstand $R_{174}$) auch Transistor $T_{85}$ leitend, so daß der Ausgangspin $A_{46}$ logisch »0« führt, also kein Überspannungskurzschluß angezeigt wird. Wird dagegen aufgrund ausgangsseitigen Überspannungskurzschlusses einer der beiden Transistoren $T_{37}$ oder $T_{73}$ gesperrt, so verkleinert sich auch die Spannung zwischen den Emittern obiger Transistoren, wodurch $T_{83}$ gesperrt wird. Dies verursacht über den Widerstand $R_{172}$ einen Basisstrom für den Transistor $T_{82}$ und die Leuchtdiode brennt. Die Halbleiter $T_{84}$ und $T_{85}$ sind jetzt gesperrt, so daß der Ausgangspin $A_{46}$ bei Anschluß eines externen Kollektorwiderstands logisch »1« wird.

**Patentansprüche**

1. Transistorgegentaktendstufe mit Gegenkopplung vom Ausgang auf den Eingang sowie hochohmigem Eingang und niederohmigem Ausgang, bei der eine Ausgangsstufe vorgesehen ist, die pro Gegentaktstufe eine Parallelschaltung aus mehreren Ausgangstransistoren ($T_H A$, $T_B A$) aufweist, wobei die Ausgangstransistoren der einen Gegentaktstufe komplementär zu den Ausgangstransistoren der anderen Gegentaktstufe ausgeführt sind, insbesondere für Impulsformer, wobei in jeder Gegentaktstufe als Eingangstransistor ein Feldeffekttransistor (T31, T76) verwendet ist, dadurch gekennzeichnet, daß der Feldeffekttransistor jeweils über eine Emitterfolgerstufe (T32, T74) die Basen der Ausgangstransistoren (THA, TBA) der zugeordneten Parallelschaltung ansteuert, daß die Basen der Ausgangstransistoren (THA, TBA) außerdem an eine Konstantstromquelle (KH, KB) angeschlossen sind, die bei Überspannung am Ausgang abgeschaltet wird, und daß Mittel (OP4, T35, OP11, T80) zur Stromversorgung vorgesehen sind, die abhängig vom Spannungshub und der Impuls-Grundspannung eines Signals gesteuert sind.

2. Transistorgegentaktendstufe nach Patentanspruch 1, dadurch gekennzeichnet, daß in Reihe zur Konstantstromquelle (KN, KB) jeder Gegentaktstufe ein gesteuerter Schalter (T36, T72) vorzugsweise ein Transistor liegt, der bei unzulässigen Überspannungen am Ausgang durch eine Überspannungsschaltung (ÜSH, ÜSB) wie z. B. eine bistabile Kippstufe, betätigt wird.

3. Transistorgegentaktendstufe nach einem der vorhergehenden Patentansprüche, dadurch gekennzeichnet, daß die Stromversorgung je Gegentaktstufe aus einem Operationsverstärker (OP11, OP4) mit nachgeschalteten Leistungstransistoren (T80, T35) besteht, in dessen Emitterkreis Widerstände (R61, R168) eingeschaltet sind, durch die zuleich der Ausgangsstrom der jeweiligen Gegentaktstufe fließt und daß im Basis-Emitter-Kreis dieser Leistungstransistoren jeweils die Kollektorstrecke eines weiteren Transistors (T33, T79) liegt, dessen Basis jeweils am Verbindungspunkt vom Emitter der Leistungstransistoren (T35, T80) und der Meßwiderstände (R61, R168) liegt.

4. Transistorgegentaktendstufe nach einem der vorhergehenden Patentansprüche, dadurch gekennzeichnet, daß die Steuereingänge der Operationsverstärker (OP4, OP11) in der Brückendiagonale einer Wheatston'schen Brücke (WB) liegen, an die auch als Steuergrößen die Hubspannung und die Impuls-Grundspannung des Signals geführt sind.

5. Transistorgegentaktendstufe nach einem der vorhergehenden Patentansprüche, dadurch gekennzeichnet, daß zwischen den Operationsverstärkern (OP4, OP11) und den Leistungstransistoren (T35, T80) Dioden (D13, D43) eingeschaltet sind.

## Claims

1. A transistor push-pull terminal stage with negative feedback from the output to the input, and with a high input resistance and a low output resistance, wherein an output stage is provided for each push-pull stage with a parallel connected of a plurality of output transistors ($T_H$A, $T_B$A), the output transistors of the first push-pull stage being complementary to the output transistors of the other push-pull stage, in particular for pulse shapers, wherein a field effect transistor (T31, T76) is used as an input transistor in each push-pull stage, characterised in that the field effect transistor in each case operates the bases of the output transistors (THA, TBA) of the assigned parallel circuit, via an emitter follower stage (T32, T74), the bases of the output transistors (THA, TBA) are further connected to a constant current source (KH, KB) which is disconnected when excess voltage occurs at the output, and means (OP4, T35, OP11, T80) for supplying current which are controlled in dependence upon the voltage range and upon the pulse fundamental voltage of a signal.

2. A transistor push-pull terminal stage as claimed in Claim 1, characterised in that a controlled switch (T36, T72), preferably a transistor, is arranged in series with the constant current source (KN, KB) of each push-pull stage, which switch is actuated in the event of impermissable excess voltages at the output by means of an excess voltage circuit (ÜSH, ÜSB) such as for example a bistable trigger stage.

3. A transistor push-pull terminal stage as claimed in one of the preceding claims, characterised in that in respect of each push-pull stage the current supply consists of an operational amplifier (OP11, OP4) followed by power transistors (T80, T35), in the emitter circuit of which there are connected resistors (R61, R168) through which the output current of the push-pull stage in question flows simultaneously, and that the base-emitter path of these power transistors in each case contains the collector path of a further transistor (T33, T79) whose base is connected to the connection point of the emitter of the power transistors (T35, T80) and the measuring resistors (R61, R168).

4. A transistor push-pull terminal stage as claimed in one of the preceding claims, characterised in that the control inputs of the operational amplifiers (OP4, OP11) are located in the bridge diagonal of a Wheatston bridge (WB) to which the range voltage and the pulse fundamental voltage of the signal are also supplied as control values.

5. A transistor push-pull end stage as claimed in one of the preceding claims, characterised in that diodes (D13, D43) are connected between the operational amplifiers (OP4, OP11) and the power transistors (T35, T80).

## Revendications

1. Etage push-pull transistorisé de sortie, avec contre-réaction de la sortie sur l'entrée, ainsi qu'avec une entrée fortement ohmique et une sortie faiblement ohmique, dans lequel est prévu un étage de sortie qui présente, par étage push-pull, un circuit parallèle de plusieurs transistors de sortie, les transistors de sortie de l'un des étages push-pull étant réalisés de façon complémentaire aux transistors de sortie de l'autre étage push-pull, en particulier pour des circuits de mise en forme d'impulsions, un transistor à effet (T31, T76) étant utilisé dans chaque étage push-pull comme transistor d'entrée, caractérisé en ce que le transistor à effet de champ commande respectivement, par l'intermédiaire d'un étage à émetteur suiveur (T32, T74) les bases des transistors de sortie (THA, TBA) du circuit en parallèle associé, que les bases des transistors de sortie (THA, TBA) sont reliées à une source de courant constant (KH, KB) qui est débranché en cas de surtension à la sortie et que des moyens (OP4, T35, OP11, T80) pour l'alimentation de courant sont prévus, qui sont commandés en fonction de l'écart de la tension et de la tension de base d'impulsion d'un signal.

2. Etage final push-pull transistorisé de sortie selon la revendication 1, caractérisé en ce qu'en série sur la source de courant constant (KH, KB) de chaque étage push-pull, est prévu un commutateur commandé (T36, T72), de préférence un transistor, qui est actionné, en cas de surtensions inadmissibles en sortie, par un circuit de surtension (ÜSH, ÜSB), tel qu'une bascule bistable par exemple.

**0 031 138**

3. Etage final push-pull transistorisé de sortie, selon l'une des revendications précédentes, caractérisé en ce que l'alimentation en courant est constituée pour chaque étage push-pull, d'un amplificateur opérationnel (OP11, OP4) suivi de transistors de puissance (T80, T35), dans le circuit d'émetteur desquels sont branchées, des résistances (R61, R168), à travers lesquelles passe le courant de sortie de chaque étage push-pull, et que dans le circuit base-émetteur de ces transistors de puissance se trouve respectivement le circuit collecteur d'un autre transistor (T33, T79) dont la base est reliée au point de liaison de l'émetteur des transistors de puissance (T35, T80) et des résistances de mesure (R61, R168).

4. Etage final push-pull transistorisé de sortie selon l'une des revendications précédentes, caractérisé en ce que les entrées de commande de l'amplificateur opérationnel (OP4, OP11) se trouvent dans la diagonale d'un pont de Wheaston (WB) auquel sont également appliquées, en tant que grandeurs de réglage, la variation de tension et la tension de base d'impulsion du signal.

5. Etage final push-pull transistorisé de sortie selon l'une des revendications précédentes, caractérisé en ce que des diodes (D13, D43) sont branchées entre les amplificateurs opérationnels (OP4, OP11) er les transistors de puissance (T35, T80).

7

# FIG 1

FIG 2